# EUROPÄISCHE PATENTSCHRIFT

(11) **EP 0 992 854 B1**
(45) Veröffentlichungstag und Bekanntmachung des Hinweises auf die Patenterteilung: **29.01.2003**
(21) Anmeldenummer: 99119227.9
(22) Anmeldetag: 28.09.1999
(51) Int. Cl.: G03F 7/32

(54) **Konzentrat und daraus hergestellter wässriger Entwickler für bildmässig bestrahlte Aufzeichnungsmaterialien**
Concentrate and aqueous developer for image-wise exposed recording materials
Concentré et révélateur aqueux pour matériaux d'enregistrement exposés sous forme d'image

(30) Priorität: 05.10.1998 DE 19845605
(43) Veröffentlichungstag der Anmeldung: 12.04.2000
(73) Patentinhaber: AGFA-GEVAERT, 2640 Mortsel (BE)
(72) Erfinder: Leichsenring, Thomas, 55129 Mainz (DE); Boxhorn, Mario, 55126 Mainz (DE); Elsässer, Andreas, Dr., 65510 Idstein (DE); Lifka, Thorsten, Dr., 65197 Wiesbaden (DE); Zertani, Rudolf, Dr., 55234 Bechtolsheim (DE)

(56) Entgegenhaltungen:
- EP-A- 0 274 044
- EP-A- 0 490 515
- EP-A- 0 720 060
- EP-A- 0 795 787
- DD-A- 287 529
- US-A- 5 670 294
- PATENT ABSTRACTS OF JAPAN vol. 1997, no. 01, 31. Januar 1997 (1997-01-31) -& JP 08 248643 A (FUJI PHOTO FILM CO LTD), 27. September 1996 (1996-09-27)
- PATENT ABSTRACTS OF JAPAN vol. 012, no. 042 (P-663), 6. Februar 1988 (1988-02-06) & JP 62 187855 A (FUJI PHOTO FILM CO LTD), 17. August 1987 (1987-08-17)

## Beschreibung

Die Erfindung betrifft ein Entwicklerkonzentrat, das Wasser, mindestens ein in Wasser alkalisch reagierendes Mittel und ein amphoteres Tensid enthält, sowie den daraus durch Verdünnen mit Wasser erhältlichen Entwickler selbst, der für bildmäßig bestrahlte Aufzeichnungsmaterialien wie Druckplatten, Photoresists, Kopiermaterialien etc. geeignet ist, sowie ein entsprechendes Regenerat.

Die bisher bekannten Entwickler weisen eine Reihe von Nachteilen auf. So enthalten sie oftmals bedeutende Anteile an organischen Lösemitteln, die wegen ihrer Feuergefährlichkeit, ihres niedrigen Siedepunkts, ihres unangenehmen Geruchs, der Belastung von Abwasser und Abluft sowie der aufwendigen Vorrichtungen zur gefahrlosen Beseitigung des verbrauchten Entwicklers unerwünscht sind. In modernen Entwicklern sollten sie daher nicht mehr vorhanden sein.

Einen hohen Anteil an organischen Lösemitteln enthalten beispielsweise die wäßrigen Entwicklerkonzentrate gemäß EP-A 432 450 (= US-A 5 155 011) und EP-A 432 451 (= US-A 5 155 012), die mit Leitungswasser zu gebrauchsfertigen Entwicklern verdünnt werden können. Die Konzentrate enthalten daneben ein alkalisch reagierendes Mittel, ein anionisches Tensid, Salze einer n-Alkansäure, Emulgatoren, Alkalisalze eines oligomeren Phosphats und/oder der N-(2-Hydroxyethyl)-ethylendiamintriessigsäure sowie einen Puffer. Gemäß der EP-A 432 450 ist der Puffer spezifiziert als Tris-hydroxyalkyl-aminomethan.

Alkalisalze der N-(2-Hydroxy-ethyl)-ethylendiamintriessigsäure sind bekanntermaßen biologisch nur schwer abbaubar. Die deutsche Industrie hat sich daher verpflichtet, die Belastung der Umwelt mit diesen Stoffen zu vermindern.

Um die Entwicklungsmaschinen einfacher reinigen zu können, enthalten die Entwickler häufig Tenside. Diese schäumen jedoch oft so stark, daß Antischaummittel zugegeben werden müssen. Der Schaum kann zudem bewirken, daß sich bereits abgelöste Schichtbestandteile erneut auf dem Aufzeichnungsmaterial ablagern oder daß diese Bestandteile in nachfolgende Stationen (Spülbad, Gummierungsstation) der Entwicklungsmaschine verschleppt werden. Bereits entwickelte Aufzeichnungsmaterialien können auf diese Weise unbrauchbar werden. Hauptsächlich bei maschineller Entwicklung lagern sich Schichtbestandteile, die in dem Entwickler in Form von Fladen, Fädchen oder Pigmentresten enthalten sind, auf den Druckformen ab.

In kontinuierlich arbeitenden Entwicklungsmaschinen wird die Zusammensetzung des Entwicklers durch laufende Zugabe von frischem Entwickler oder von einem speziellen Regenerat konstant gehalten. Die erforderlichen Zugabeintervalle lassen sich beispielsweise durch Bestimmung der Leitfähigkeit des Entwicklers steuern. Die Einwirkung von Bestandteilen der Umgebungsluft (Sauerstoff, Kohlendioxid) beeinflußt die Leitfähigkeit des Entwicklers relativ wenig, hat jedoch einen großen Einfluß auf die Entwickleraktivität. Die Leitfähigkeitssteuerung ist folglich nicht in der Lage, einen durch Oxidation oder Carbonatbildung in seiner Aktivität verminderten Entwickler nach längerer Stillstandszeit in ausreichendem Maße wieder zu kompensieren. Das Entwicklungsergebnis verschlechtert sich infolgedessen.

Ein Verfahren zur Herstellung einer lithographischen Druckplatte, bei dem ein bildmäßig belichtetes Aufzeichnungsmaterial, dessen Rückseite mit einer Schicht aus einem organischen Polymer überzogen ist, mit einem Alkalisilikat-Entwickler entwickelt wird, ist in der EP-B 490 515 offenbart. Dabei wird der Entwickler mit einer wäßrigen Alkalisilikat-Lösung regeneriert, in der das [SiO₂] : [M₂O]-Molverhältnis im Bereich von 0,3 bis 1,0 und der SiO₂-Gehalt im Bereich von 0,5 bis 4 Gew.-% liegt. Der Entwickler und/oder das Regenerat können darüber hinaus organische Lösemittel, Tenside und/oder Antischaummittel enthalten. Die Tenside können anionischer, kationischer, amphoterer oder nichtionischer Natur sein.

Ein von organischen Lösemitteln freier Entwickler für positiv und negativ arbeitende Aufzeichnungsmaterialien ist in der JP-A 62-187 855 offenbart. Er enthält 1 bis 10 Gew.-% Alkalimetallsilikat und 0,1 bis 5 Gew.-% eines amphoteren oder anionischen Tensids.

In der EP-A 732 628 ist ein Entwickler und ein entsprechendes Konzentrat offenbart, das neben Alkalimetallsilikaten nichtionische, anionische oder amphotere Netzmittel enthält. Der Entwickler besitzt eine höhere Entwicklungskapazität, entwickelt weniger Schaum und neigt weniger zur Ablagerung von Schichtbestandteilen auf den Platten oder in den automatischen Entwicklungsanlagen.

In dem Verfahren zur Herstellung einer lithographischen Druckplatte gemäß der JP-A 8-248 643 wird ein Aufzeichnungsmaterial mit einer bildmäßig bestrahlten, photopolymerisierbaren Schicht mit einem Alkalimetallsilikat-Entwickler entwickelt. Zur Regenerierung wird dem Entwickler ebenfalls eine Alkalimetallsilikatlösung zugesetzt. Entwickler und/oder Regenerat enthalten ein amphoteres, oberflächenaktives Mittel, vom Betain-, Glycin-, Alanin- oder Sulfobetain-Typ. Der Entwickler ist besonders für automatische Entwicklungsanlagen vorgesehen. Als besonderer Vorzug ist angegeben, daß sich in diesem Entwickler beim Gebrauch keine festen oder gelartigen Ausfällungen bilden.

Der Entwickler für Positiv-, Negativ- oder Umkehrplatten gemäß der EP-A 274 044 enthält 5 bis 30 Gew.-% eines alkalisch reagierenden Mittels, insbesondere Natriummetasilikat, und 0,01 bis 10 Gew.-% eines Ethylenoxid/Propylenoxid-Blockcopolymers. Das Blockcopolymer kann dabei auch aus Ethylenoxid, Propylenoxid und Ethylendiamin hergestellt sein. Der Entwickler kann darüber hinaus noch Entschäumer oder Enthärter enthalten.

Um zu vermeiden, daß sich Ausfällungen aus dem Entwickler auf den Platten absetzen - die beim späteren Drucken eine unerwünschte Farbübertragung (= "Tonen") in Nichtbildstellen bewirken - enthält der Entwickler gemäß der EP-A 720 060 Enthärter vom Alanintyp mit mindestens 3 COOA-Einheiten, wobei A = H, Na, K, NH₄ oder NR₄ (R = Alkyl) ist.

Nach wie vor besteht jedoch die Aufgabe, einen Entwickler zu schaffen, der für bildmäßig bestrahlte, positiv, negativ oder im Umkehrverfahren arbeitende Reproduktionsschichten geeignet ist, dabei eine hohe Entwicklungskapazität aufweist (möglichst höher als die von bekannten Entwicklern) und gleichzeitig nicht zur Bildung von unerwünschten Ablagerungen auf den bereits entwickelten Platten oder in den Entwicklungsanlagen neigt. Der Entwickler soll sich ferner in Form eines Entwickler- bzw. Regeneratkonzentrats in den Handel bringen lassen, um Transport- und Lagerkapazitäten zu vermindern. Aus dem Konzentrat wird dann durch Verdünnen mit (Leitungs-)Wasser der gebrauchsfertige Entwickler bzw. das gebrauchsfertige Regenerat hergestellt. Viele bekannte Entwickler müssen dagegen von vornherein in verdünnter Form zur Verfügung gestellt werden, da die entsprechenden Konzentrate sich über kürzere oder längere Zeit entmischen und/oder Niederschläge bilden, insbesondere bei niedrigen Lagertemperaturen.

Gelöst wird die Aufgabe durch ein Entwicklerkonzentrat, das Wasser, mindestens ein in Wasser alkalisch reagierendes Mittel und ein amphoteres Tensid enthält, und das dadurch gekennzeichnet ist, daß es zusätzlich mindestens ein anionisches Tensid, mindestens einen Komplexbildner, mindestens einen Aminoalkohol und mindestens ein N-alkoxyliertes ein- oder mehrfunktionelles Amin enthält.

Das in Wasser alkalisch reagierende Mittel ist bevorzugt ein Alkali-, Erdalkali-oder Ammoniumhydroxid, insbesondere LiOH, KOH oder NaOH oder ein Alkali-, Erdalkali- oder Ammoniumsalz einer anorganischen oder organischen Säure, insbesondere Natrium- oder Kaliumdihydrogenphosphat, Dinatrium- oder Dikaliumhydrogenphosphat, Natrium- oder Kaliummetasilikat, Natriumborat, ein Alkalimetallsalz einer aliphatischen, aromatischen oder araliphatischen Carbonsäure, insbesondere ein Alkalimetallsalz einer (C₂-C₁₀)Alkansäure oder einer (C₃-C₁₂)Alkoxyalkansäure.

Der Anteil des alkalisch wirkenden Mittels beträgt allgemein 0,5 bis 25 Gew.-%, bevorzugt 0,7 bis 15 Gew.-%, jeweils bezogen auf das Gesamtgewicht des Konzentrats. Der pH-Wert des Konzentrats beträgt allgemein mindestens 11, bevorzugt mindestens 12.

Das amphotere Tensid ist bevorzugt eine Aminosäure oder ein Salz davon oder ein Alkylamidoalkylbetain der Formel

CₙH₂ₙ₊₁-CO-NH-CₘH₂ₘ-N⁺((C₁-C₆)Alkyl)₂-CₚH₂ₚ-X⁻

wobei
- X⁻: eine Carboxylat-, Sulfonat-, Sulfat- oder Phosphonatgruppe darstellt,
- n: eine ganze Zahl von 8 bis 25 und
- m, p: eine ganze Zahl von 2 bis 10.

Herstellen lassen sich die Alkylamidoalkylbetaine aus Fettsäuren CₙH₂ₙ₊₁-COOH, die zunächst mit N,N-dialkyl-substitituierten Diaminen der Formel H₂N-CₘH₂ₘ-N((C₁-C₆)-Alkyl)₂ zu den entsprechenden Amiden umgesetzt werden. Die tertiäre Aminogruppe wird dann quaterniert mit Verbindungen, die mindestens anionische Gruppen enthalten bzw. bilden können. Die Aminosäure bzw. das Aminosäuresalz entsprechen vorzugsweise den Formeln

R²R³N-R¹-COOR⁴

oder

R²R³N-R¹-NR⁵-R⁷-COOR⁴

wobei
- R¹ und R⁷: gleich oder verschieden sind und eine geradkettige oder verzweigte (C₁-C₁₈)Alkylengruppe, in der einzelne Methylengruppen durch Sauerstoffatome ersetzt sein können, darstellen,
- R² und R³: gleich oder verschieden sind und für ein Wasserstoffatom, eine (C₁-C₂₂)Alkylgruppe, in der einzelne CH₂-Gruppen durch Sauerstoffatome oder NH-Gruppen ersetzt sein können, eine Carboxy(C₁-C₂₂)alkylgruppe, deren Carboxygruppe auch als Lithium-, Natrium-, Kalium- oder Ammoniumcarboxylatgruppe vorliegen kann, eine (C₂-C₂₂)Alkenylgruppe, eine gegebenenfalls substituiert (C₄-C₈)Cycloalkylgruppe oder eine (C₂-C₂₃)Alkanoylgruppe stehen,
- R⁴: ein Wasserstoff-, Lithium-, Natrium- oder Kaliumatom oder eine Ammoniumgruppe der Formel NR₄, wobei R ein Wasserstoffatom, eine (C₁-C₁₀)Alkylgruppe, eine (C₆-C₁₄)Arylgruppe, eine (C₇-C₂₀)Aralkylgruppe oder eine mit einer oder mehreren (C₁-C₆)Alkylgruppen substituierte Arylgruppe, wobei jede dieser Gruppen gegebenenfalls noch mit einer oder mehreren Hydroxygruppen substituiert sein kann, und
- R⁵: für ein Wasserstoffatom, eine (C₁-C₂₂)Alkylgruppe, in der einzelne CH₂-Gruppen durch Sauerstoffatome oder NH-Gruppen ersetzt sein können, eine (C₂-C₁₀)Hydroxyalkyl-, eine (C₁-C₂₂)Alkenyl- oder eine (C₂-C₂₃)Alkanoylgruppe steht.

Bevorzugte amphotere Tenside sind ferner Betaine der Formel

R²R³N-R¹-N⁺R⁵R⁶-R⁷-COO⁻

wobei R¹ bis R³ die oben angegebene Bedeutung haben und
- R⁵ und R⁶: gleich oder verschieden sind und für ein Wasserstoffatom, eine (C₁-C₂₂)Alkylgruppe, in der einzelne CH₂-Gruppen durch Sauerstoffatome oder NH-Gruppen ersetzt sein können, eine (C₁-C₂₂)Alkenylgruppe oder eine (C₂-C₂₃)Alkanoylgruppe steht, wobei R⁵ und R⁶ zusammen auch einen Ring bilden können.

Der Anteil des amphoteren Tensids beträgt allgemein 0,3 bis 25 Gew.-%, bevorzugt 0,5 bis 15 Gew.-%, jeweils bezogen auf das Gesamtgewicht des **Konzentrats.**

Das anionische Tensid ist vorzugsweise ein (C₂-C₁₆)Alkylsulfat, (C₆-C₁₂)Arylsulfat, (C₇-C₂₀)Aralkylsulfat, (C₁-C₁₅)Alkyl-(C₆-C₁₂)Arylsulfat, (C₂-C₁₆)Alkenylsulfat oder (C₃-C₁₆)Alkoxyalkylsulfat. Die Verbindungen sind gegebenenfalls substituiert. Beispiele dafür sind Octylsulfat, Cumolsulfat und Rizinusölsulfat. Anstelle der Sulfate können natürlich auch die entsprechenden Sulfonate oder Carboxylate eingesetzt werden. Die anionischen Tenside können auch mehrere gleiche oder verschiedene anionische Gruppen aufweisen. Zu nennen sind hier beispielsweise Alkoxyalkyldicarboxylate. Der Anteil der anionischen Tenside beträgt allgemein 0,5 bis 20 Gew.-%, bevorzugt 1 bis 15 Gew.-%, jeweils bezogen auf das Gesamtgewicht des Konzentrats.

Der Komplexbildner ist bevorzugt Gluconsäure, ein Alkali-, Erdalkali- oder Ammoniumsalz der Gluconsäure oder Gluconsäure*-delta*-lacton. Diese Komplexbildner haben den weiteren Vorteil, daß sie besonders umweltfreundlich (sie werden sogar in Lebensmitteln verwendet) und biologisch leicht abbaubar sind. Zudem bewirken bereits geringe Mengen davon eine sehr hohe Enthärtung. Als Komplexbildner sind ferner Polyphosphate, Alanin- oder Ethylendiamin-Derivate, insbesondere EDTA-Derivate, zu nennen. Der Anteil der Komplexbildner beträgt allgemein 2 bis 20 Gew.-%, bevorzugt 4 bis 15 Gew.-%, jeweils bezogen auf das Gesamtgewicht des Konzentrats.

Bei dem Aminoalkohol handelt es sich allgemein um ein primäres, sekundäres oder tertiäres aliphatisches Amin mit mindestens einer, bevorzugt 2 bis 5 Hydroxygruppen, vorzugsweise primären oder sekundären Hydroxygruppen. Es umfaßt in der Regel nicht mehr als 60 Kohlenstoffatome. Dazu gehören beispielsweise 2-Hydroxy-1,1-bis-hydroxymethyl-ethylamin (= Tris-hydroxymethylaminomethan) und Triethanolamin.

Das N-alkoxylierte, ein- oder mehrwertige Amin ist bevorzugt ein ethoxyliertes oder propoxyliertes (C₁-C₁₀)Alkylamin, (C₂-C₁₀)Alkylendiamin, Triamin oder Tetraamin. Dazu gehören beispielsweise Ethylendiamine, die mit Ethylenoxid und/oder Propylenoxid umgesetzt wurden. Die alkoxylierten Aminogruppen enthalten vorzugsweise eine oder 2 Kette(n) aus (jeweils) 2 bis 25 Alkylenoxid-Einheiten. Der Anteil der N-alkoxylierten, ein- oder mehrwertigen Amine beträgt 0,2 bis 20 Gew.-%, bevorzugt 0,4 bis 10 Gew.-%, jeweils bezogen auf das Gesamtgewicht des Konzentrats.

Das erfindungsgemäße Entwicklerkonzentrat kann darüber hinaus, je nach Art der zu entwickelnden Aufzeichnungsmaterialien, weitere Bestandteile enthalten. Dazu gehören insbesondere aliphatische oder aromatische Alkohole, speziell (C₁-C₁₂)Alkanole, (C₃-C₂₀)Alkoxyalkanole, gegebenenfalls substituiertes Phenol oder Benzylalkohol. Femer gehören dazu nichtionische Tenside, bevorzugt alkoxylierte (speziell ethoxylierte oder propoxylierte), gesättigte oder ungesättigte aliphatische oder aromatische Alkohole. Der Anteil der nichtionischen Tenside beträgt allgemein 0,1 bis 20 Gew.-%, bevorzugt 0,5 bis 12 Gew.-%. Schließlich können auch kationische Tenside in dem Konzentrat vorkommen.

Das Konzentrat kann mit Leitungswasser im Verhältnis von 1 : 0,5 bis 1 : 10, bevorzugt im Verhältnis von 1 : 2 bis 1 : 6, zu einem gebrauchsfertigen Entwickler verdünnt werden.

Gegenstand der vorliegenden Erfindung ist schließlich auch ein Regeneratkonzentrat. Dieses Konzentrat unterscheidet sich von dem Entwicklerkonzentrat dadurch, daß darin die Konzentration des mindestens einen in Wasser alkalisch reagierenden Mittels um 10 bis 700 %, bevorzugt 50 bis 300 %, höher ist und auch die Konzentrationen der anderen Bestandteile bis zu 70 %, bevorzugt bis zu 50 %, von denen des Entwicklerkonzentrats abweichen. Aus dem Regeneratkonzentrat wird ebenfalls durch Verdünnen mit Leitungswasser im Verhältnis von 1 : 0,5 bis 1 : 10, bevorzugt im Verhältnis von 1 : 2 bis 1 : 6, das gebrauchsfertige Regenerat hergestellt. Das Regenerat wird einem teilweise verbrauchten Entwickler zugesetzt, um seine volle Wirksamkeit wieder herzustellen.

Beim Verdünnen mit einem Leitungswasser, das Permanenthärtebildner (insbesondere Magnesium- oder Calciumionen) enthält, werden keine Niederschläge oder unlöslichen Bestandteile gebildet. Solche Ausfällungen können die Funktion der Entwicklungsmaschine beeinträchtigen und sich auch auf den Druckplatten ablagern, was beim Drucken zu Störungen bei der Farbannahme führt.

Der erfindungsgemäße Entwickler ist für die meisten der auf dem Markt befindlichen positiv, negativ oder im Umkehrverfahren arbeitenden Aufzeichnungsmaterialien geeignet, insbesondere für solche, deren Reproduktionsschicht noch mit einer oder mehreren wasserlöslichen oder in Wasser dispergierbaren Deckschichten bzw. Überzugsschichten (top coat) versehen ist. Ein entscheidender Vorteil des erfindungsgemäßen Entwicklers liegt in seiner besonders hohen Entwicklungskapazität. Der Verbrauch an Entwickler pro Quadratmeter Aufzeichnungsmaterial sinkt damit deutlich, so daß der Entwickler weniger oft erneuert werden muß. Die Anzahl der Entwicklerwechsel kann bis auf etwa die Hälfte reduziert werden, je nach Regeneratzusatz. Produktionsstillstand wird so vermieden und auch der Arbeitsaufwand verringert sich. Auch können die Entwicklungsapparate durch einfaches Ausspülen mit Wasser gereinigt werden. Spezielle Reinigungsmittel werden nicht mehr benötigt. Die bisher für diesen Zweck verwendeten Reinigungsmittel sind in aller Regel gefährlich, umweltschädlich und teuer. Ablagerungen auf den entwickelten Platten werden nicht beobachtet. Deshalb ist es auch nicht mehr erforderlich, spezielle Filter oder andere Vorrichtungen zum Abtrennen von festen Bestandteilen in den Entwicklungsmaschinen vorzusehen.

Die genannten N-alkoxylierten, ein- oder mehrwertigen Amine lassen den Entwickler nur wenig schäumen und wirken gleichzeitig emulgierend auf Schichtbestandteile aus dem Aufzeichnungsmaterial. Die Schaumbildung kann zwar auch durch Zugabe von Entschäumem gebremst werden, bei nicht korrekter Dosierung besteht jedoch ein hohes Risiko, daß das Aufzeichnungsmaterial geschädigt wird und beim Drucken schlechte Ergebnisse erzielt werden. Herkömmliche Entschäumer, beispielsweise Silikon-Emulsionen, lassen in alkalischen Medien zudem mit der Zeit in ihrer Wirksamkeit nach. Die Verwendung von Entschäumern ist daher stets mit erhöhtem Kontrollaufwand verbunden. Die erfindungsgemäßen Entwickler können in allen bekannten Entwicklungsvorrichtungen eingesetzt werden, beispielsweise in Tauchbadmaschinen, Flachtischmaschinen mit rotierenden oder oszillierenden Bürsten oder (Hochdruck)Sprühentwicklungsmaschinen. Bisher war es dagegen häufig erforderlich, spezielle Entwicklungsvorrichtungen zu benutzen, bei denen die Bürsten gekapselt oder vollständig von Entwickler umgeben sind, um unerwünschte Schaumbildung zu vermeiden. Daneben war es oft erforderlich, die Zuführungsleitungen für den Entwickler unter die Flüssigkeitsoberfläche zu verlegen, den Entwickler in einem speziellen Zwangskreislauf zu halten oder die Entwicklungszone mit einer speziellen Abdeckung zu versehen.

Mit dem erfindungsgemäßen Entwickler läßt sich eine Vielzahl von bildmäßig bestrahlten Reproduktionsschichten entwickeln. Diese Schichten können als strahlungsempfindliche Komponente Diazoniumsalz-Polykondensationsprodukte, Chinondiazidverbindungen, bevorzugt *ortho*-Chinondiazide, Kombinationen von polymerisierbaren, ethylenisch ungesättigten Monomeren und Photopolymerisationsinitiatoren und/oder Kombinationen von säurespaltbaren Verbindungen und Verbindungen, die bei Bestrahlung Säure bilden, enthalten. Daneben können noch polymere Bindemittel, Weichmacher, Sensibilisatorfarbstoffe, sonstige Farbstoffe oder Pigmente, Steuersubstanzen, Bestrahlungsindikatoren, oberflächenaktive Mittel und/oder Netzmittel hinzugefügt sein.

Als Bindemittel in strahlungsempfindlichen Schichten sind besonders Polymere geeignet, die in Wasser unlöslich, in organischen Lösemitteln und in wäßrigalkalischen Lösungen dagegen löslich oder zumindest quellbar sind. Besonders geeignet sind Polymere mit seitenständigen Carboxylgruppen, beispielsweise Copolymere mit Einheiten aus (Meth)acrylsäure, Crotonsäure oder Maleinsäurehalbester oder Polymere mit Hydroxygruppen, von denen einige oder alle mit cyclischen Dicarbonsäureanhydriden umgesetzt sind. Die polymeren Bindemittel haben allgemein ein Molekulargewicht M_{w} von 500 bis 1.000.000, insbesondere von 1.000 bis 200.000, und eine Säurezahl von 10 bis 250, bevorzugt von 20 und 200. Bevorzugte Bindemittel sind Co- bzw. Mischpolymere der (Meth)acrylsäure, der Crotonsäure oder der Vinylessigsäure. Die Comonomere sind dabei insbesondere Alkyl(meth)acrylate, Hydroxyalkyl(meth)acrylate, Allyl(meth)acrylate, Aryl(meth)acrylate und/oder (Meth)acrylnitril. Zu nennen sind ferner Copolymere aus Maleinsäureanhydrid und gegebenenfalls substiuierten Styrolen, ungesättigten Kohlenwasserstoffen, ungesättigten Ethem oder Estern. Die darin enthaltenen Anhydridgruppen können auch verestert sein. Der Anteil der Bindemittel in dem strahlungsempfindlichen Gemisch beträgt allgemein 20 bis 90 Gew.-%, bevorzugt 40 bis 80 Gew.-%.

Die Monomere in den photopolymerisierbaren Gemischen sind allgemein ethylenisch ungesättigte Verbindungen, insbesondere Acrylsäureester oder Methacrylsäureester von zwei- oder mehrwertigen Alkoholen. Zu nennen sind speziell Ethylenglykol-di(meth)acrylat, Diethylenglykol-di(meth)acrylat, (Meth)acrylate von Trimethylolethan, Trimethylolpropan, Pentaerythrit, Dipentaerythrit und von mehrwertigen alicyclischen Alkoholen. Mit Vorteil lassen sich auch Umsetzungsprodukte von Mono- oder Diisocyanaten mit Partialestem mehrwertiger Alkohole einsetzen. Geeignet sind schließlich auch polymerisierbare Verbindungen, die zusätzlich photooxidierbare Gruppen, gegebenenfalls auch Urethangruppen, enthalten. Die photooxidierbaren Gruppen sind allgemein Amino-, Harnstoff- oder Thiogruppen, die auch Bestandteil heterocyclischer Ringe sein können. Speziell geeignete photooxidierbare Gruppen sind Triethanolamino-, Triphenylamino-, Thioharnstoff-, Imidazol-, Oxazol-, Thiazol-, Acetylacetonyl-, N-Phenyl-glycin- und Ascorbinsäuregruppen. Von diesen sind die polymerisierbaren Verbindungen mit primären, sekundären, insbesondere jedoch tertiären Aminogruppen bevorzugt.

Die Photoinitiatoren können aus einer Reihe von Substanzklassen ausgewählt werden. Zu nennen sind insbesondere Derivate des Benzophenons, Acetophenons, Benzoins, Benzils, Fluorenons, Thioxanthons, Acridins oder Chinazolins sowie von mehrkernigen Chinonen. Erwähnung verdienen ferner Trichlormethyl-striazine, 2-Halogenmethyl-5-vinyl-[1,3,4]oxadiazol-Derivate, mit Trichlormethylgruppen substituierte Halogenoxazole und Trihalogenmethylgruppen enthaltende Carbonylmethylenheterocyclen (EP-A 135 863 = US-A 4 966 828). Geeignet sind schließlich auch Alkyl-bis-acyl-phosphinoxide, Alkylaryl-bis-acyl-phosphinoxide, Titanocene, Ferrocene, Azidosulfonylphenylphthalimide, Ketoximether, Oniumverbindungen (speziell Diaryliodonium-, Diazonium- oder Sulfoniumverbindungen).

Als Sensibilisatorfarbstoffe kann die strahlungsempfindliche Schicht insbesondere photoreduzierbare Xanthen-, Fluoren-, Benzoxanthen-, Benzothioxanthen-, Thiazin-, Oxazin-, Cumarin-, Pyronin-, Porphyrin-, Acridin-, Azo-, Disazo-, Cyanin-, Merocyanin-, Diarylmethyl-, Triarylmethyl-, Anthrachinon-, Phenylendiamin-, Benzimidazol-, Fluorochrom-, Chinolin-, Tetrazol-, Naphthol-, Benzidin-, Rhodamin-, Indigo- und/oder Indanthrenfarbstoffe enthalten. Der Anteil der Sensibilisatorfarbstoffe beträgt allgemein 0,01 bis 15 Gew.-%, bevorzugt 0,05 bis 5 Gew.-%, jeweils bezogen auf das Gesamtgewicht der nichtflüchtigen Bestandteile der strahlungsempfindlichen Schicht.

Zur weiteren Steigerung der Lichtempfindlichkeit kann die Schicht zusätzlich noch Co-initiatoren enthalten. Bekannt ist beispielsweise die Kombination von Titanocenen und Trichlormethyl-s-triazinen, von Titanocenen und Ketoximethern sowie von Acridinen und Trichlormethyl-s-triazinen. Eine weitere Empfindlichkeitssteigerung kann durch Zugabe von Dibenzalaceton- oder Aminosäure-Derivaten erreicht werden. Der Anteil des bzw. der Initiatoren bzw. Coinitiatoren beträgt allgemein 0,01 bis 20 Gew.-%, bevorzugt 0,05 bis 10 Gew.-%, jeweils bezogen auf das Gesamtgewicht der nichtflüchtigen Bestandteile der strahlungsempfindlichen Schicht.

Zum Anfärben der strahlungsempfindlichen Schicht können Farbstoffe oder Pigmente zugesetzt sein. Für diesen Zweck werden allgemein Phthalocyanin-, Rhodamin-, Triarylmethan-, Azo-, Disazo-, Anthrachinon-, Naphthol- oder Phenylendiaminfarbstoffe oder auch anorganische Farbpigmente eingesetzt.

Zur Einstellung bestimmter Eigenschaften können ferner Inhibitoren und Steuersubstanzen in der Schicht vorhanden sein. Dazu gehören Benzophenonverbindungen, Phosphorverbindungen, Cycloacetale, Chinone, Chinoline, Naphthochinone, Anthrachinone, Ether, sterisch gehinderte Amine, Benzothiazole, Thiurame, Thiocarbamate, Phenole, Naphthole, Benzimidazole, Mercaptobenzimidazole und Phenylendiamine. Anteil der Inhibitoren und/oder Steuersubstanzen beträgt allgemein 0,001 bis 10 Gew.-%, bevorzugt 0,005 bis 5 Gew.-%, jeweils bezogen auf das Gesamtgewicht der nichtflüchtigen Bestandteile der strahlungsempfindlichen Schicht.

Die gegebenenfalls in den Aufzeichnungsmaterialien vorhandenen Überzugsschichten bestehen im wesentlichen aus wasserlöslichen oder wasseremulgierbaren polymeren Bindemitteln. Sie können daneben noch Netzmittel, Haftvermittler, Entschäumer, Farbstoffe und andere Hilfsstoffe enthalten. Solche Deckschichten sind dem Fachmann ebenfalls bekannt.

Der Entwickler gemäß der vorliegenden Erfindung ist in erster Linie vorgesehen für die Herstellung von Druckformen für den Flachdruck, Hochdruck, Tiefdruck oder Siebdruck, daneben auch von Photoresistbildern. Er kann jedoch auch bei der Herstellung von Reliefkopien (beispielsweise von Texten in Blindenschrift), von Gerbbildem oder Pigmentbildern eingesetzt werden.

Die Schichtträger in den genannten Druckformen bestehen vorzugsweise aus Metall, insbesondere aus Aluminium, Stahl, Zink, Kupfer oder Metall-Legierungen, aus Kunststoff, insbesondere Polyethylenterephthalat (PET), Celluloseacetat oder Polyamid (PA). Träger für Siebdruckschablonen bestehen insbesondere aus Perlongaze. Bei Photoresists ist der Träger allgemein ein Silicium-Wafer.

Die Oberfläche der Träger ist in vielen Fällen vorbehandelt. So sind Aluminiumträger häufig mechanisch und/oder chemisch und/oder elektrochemisch aufgerauht, anodisch oxidiert und/oder hydrophiliert. Solche Vorbehandlungen bewirken, daß die Reproduktionsschicht besser daran haftet, damit lithographischen Eigenschaften des Trägers - insbesondere sein Wasserannahme und -haltevermögen - verbessert werden oder damit der Träger bei der bildmäßigen Bestrahlung weniger stark reflektiert (Lichthofschutz). Die gleiche Wirkung läßt sich durch Aufbringen spezieller Schichten die beispielsweise aus Bindemitteln, Pigmenten und gegebenenfalls Additiven besteht, auf den Träger erreichen.

Die Herstellung der strahlungsempfindlichen Aufzeichnungsmaterialien erfolgt nach Verfahren, die dem Fachmann an sich bekannt sind. Allgemein werden die Bestandteile der strahlungsempfindlichen Schicht in einem organischen Lösemittel oder Lösemittelgemisch gelöst oder dispergiert, die Lösung bzw. Dispersion durch Aufgießen, Aufsprühen, Tauchen, Walzenantrag oder auf ähnliche Weise auf den vorgesehenen Träger aufgebracht und die Lösemittel beim anschließenden Trocknen entfernt.

Die bildmäßige Bestrahlung erfolgt mit Röhren-, Xenonimpuls-, Xenonbogen-, metallhalogeniddotierten Quecksilberdampf-Hochdruck-und Kohlenbogenlampen. Darüber hinaus ist das Belichten in üblichen Projektions- und Vergrößerungsgeräten unter dem Licht der Metallfadenlampen und Kontaktbelichtung mit gewöhnlichen Wolfram-Glühfadenlampen möglich. Auch mit kohärentem Licht eines Lasers kann bildmäßig bestrahlt werden. Geeignet sind leistungsgerechte Laser, beispielsweise Argon-Ionen-, Krypton-Ionen-, Farbstoff-, Festkörper-, Helium-Cadmium-, Helium-Neon-Laser, die insbesondere zwischen 250 und 1100nm, bevorzugt zwischen 400 und 700nm, emittieren. Der Laserstrahl kann durch ein vorgegebenes Programm gesteuert werden und die Belichtung mit Strich- und Rasterbewegungen ausführen.

Die Erfindung betrifft auch ein Verfahren zur Herstellung einer Druckform, wobei man auf einen Träger, vorzugsweise aus Aluminium oder dessen Legierungen, der insbesondere mechanisch und/oder chemisch und/oder elektrochemisch vorbehandelt und/oder hydrophiliert ist, eine positiv, negativ oder im Umkehrverfahren arbeitende Reproduktionsschicht aufbringt, bildmäßig belichtet und anschließend mit einem Entwickler, der durch Verdünnen des erfindungsgemäßen Konzentrats mit Wasser hergestellt wird, entwickelt.

Die Erfindung wird durch nachstehende Beispiele näher erläutert, ohne sie hierauf zu beschränken. Sofern nicht anders angegeben, stehen Gewichtsteile(Gt) und Volumenteile (Vt) im Verhältnis von g zu ml. Prozent- und Mengenverhältnisse sind in Gewichtseinheiten zu verstehen.

### Beispiele

Photopolymerdruckplatten ®Ozasol N90A der Agfa-Gevaert AG wurden mit einem Laserbelichter Polaris 100 der Firma Strobbe identisch auf 3 Stufen mit maximaler Dichte eines Graustufenkeiles mit einer Keilstufendichtedifferenz ΔD=0,15 belichtet. Danach wurden die Druckplatten ca. 5 s bei 100 °C thermisch behandelt.

Die Druckplatte N90A ist eine Zweischichtplatte, die auf einem hydrophilierten lithographischen Aluminiumträger eine lichtempfindliche Photopolymerschicht und eine wasserlösliche Schutzschicht besitzt.

### Beispiel 1

Die Verarbeitung der Druckplatten erfolgte in einer Verarbeitungsmaschine VSO 85 der Firma Glunz und Jensen. Die Entwickler der Tabelle 1 wurden jeweils in die Entwicklungsmaschine eingefüllt, durch Düsen auf die Plattenoberfläche gepumpt und durch eine oszillierende Bürste verteilt. Die löslichen Druckplattenbestandteile wurden ausgerieben. Nach jeweils 20m² unbelichteten Druckplattenmaterials N90A wurde eine belichtete Platte verarbeitet. Die Regenerierung erfolgte im Top-up-Verfahren mit dem entsprechenden Entwickler mit 30 ml/m².

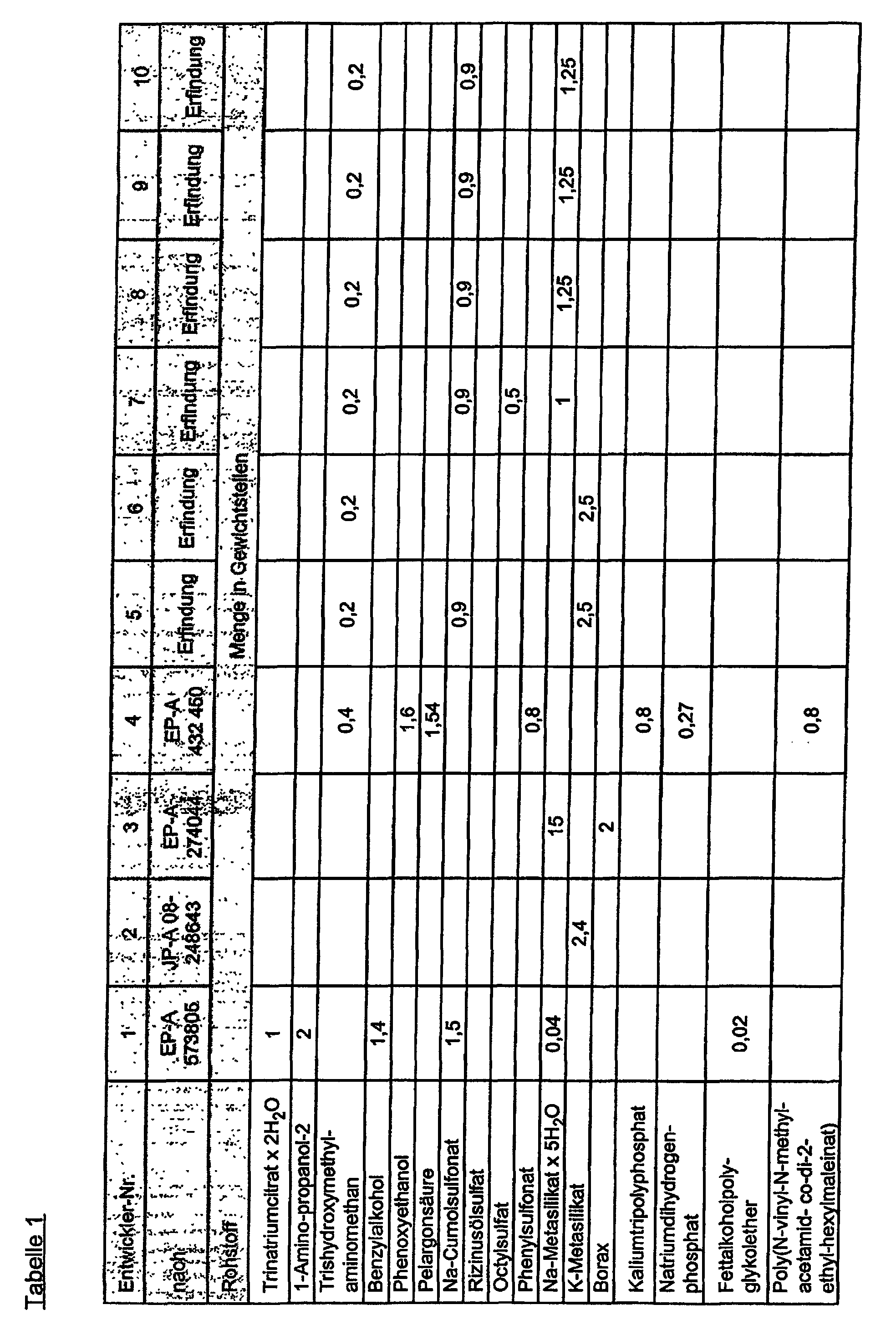

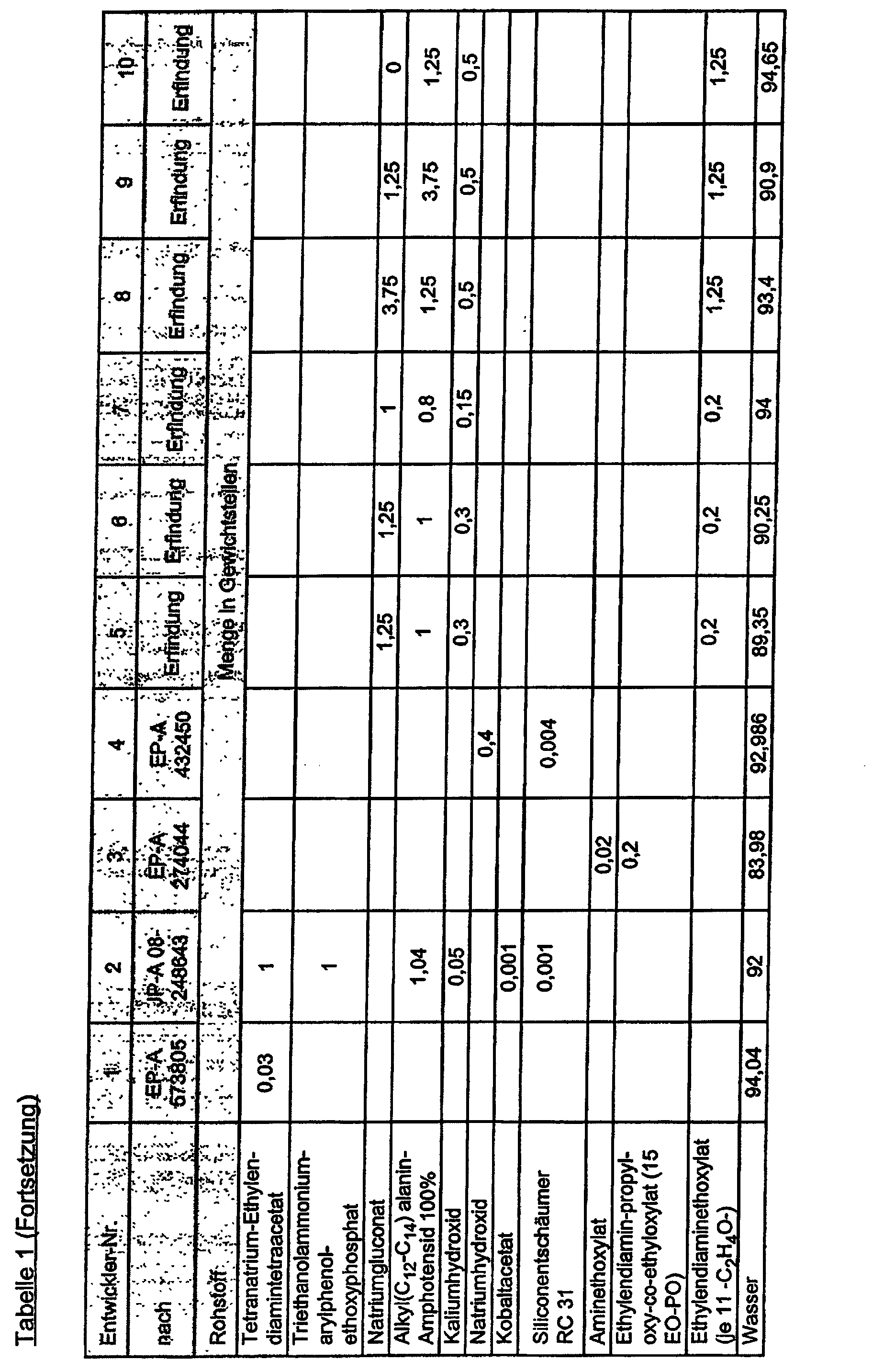

Die Beurteilung der Entwickler erfolgte nach der erreichbaren Entwicklungskapazität belichteter Druckplatten. Der Versuch wurde abgebrochen nachdem die ersten Redeponierungen auf der Druckplatte festgestellt wurden.

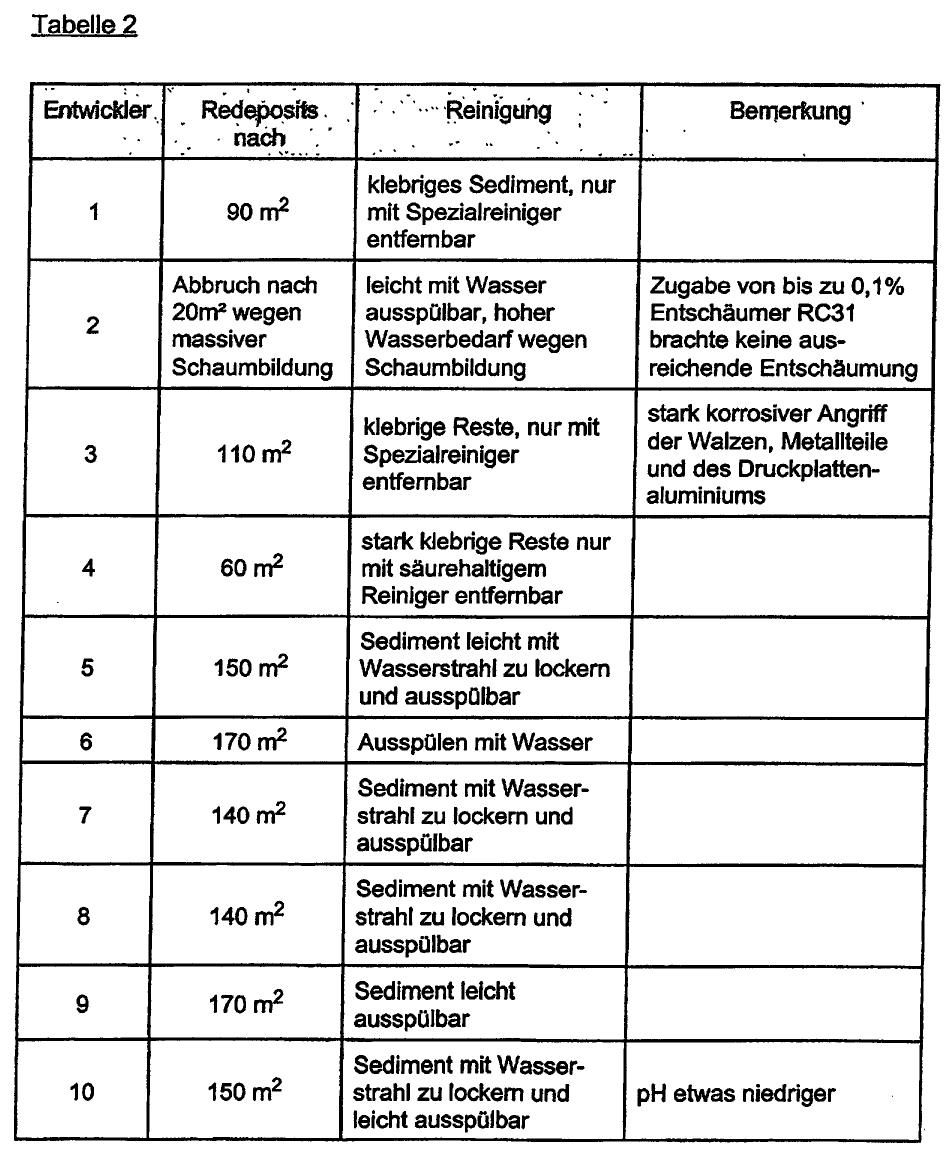

### Beispiel 2

Die Verarbeitung der Druckplatten erfolgte in einer Verarbeitungsmaschine VSC 85 der Technigraph Ltd. Dazu wurden die Entwickler der Tabelle 1 jeweils in die Entwicklungsmaschine eingefüllt, in der die Entwicklungszone als Tauchbad ausgeführt war, so daß die Druckplatten beim Entwicklungsprozeß durch die Entwicklerflüssigkeit hindurchgeführt wurden. Sprührohre im Entwicklerbad gewährleisteten einen zirkulierenden Entwicklerantrag. Zwei rotierende Bürsten rieben die löslichen Druckplattenbestandteile aus.

Nach jeweils 20m² unbelichteten Druckplattenmaterials N90A wurde eine belichtete Platte verarbeitet. Die Regenerierung erfolgte im Top-up-Verfahren mit dem entsprechenden Entwickler mit 30 ml/m². Die Beurteilung der Entwickler erfolgte nach der erreichbaren Entwicklungskapazität belichteter Druckplatten. Der Versuch wurde abgebrochen, nachdem die ersten Redeponierungen von Schichtresten auf der Druckplatte festgestellt wurden.

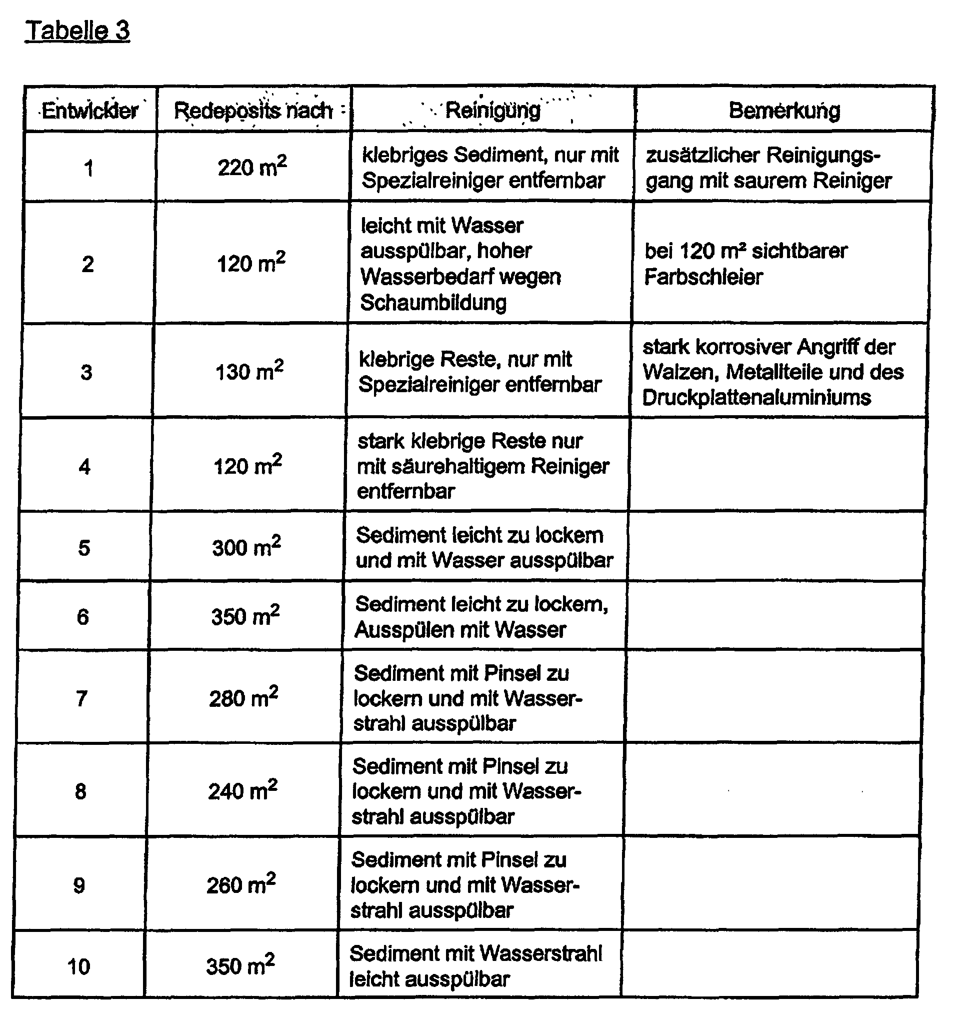

### Beispiel 3

Alle Entwickler der Tabelle 1 wurden einem Schaumtest unterzogen. Dazu wurden 20 ml des Entwicklers, unter Vermeidung von Schaumentstehung, in einen verschließbaren 100 ml - Meßzylinder gefüllt und 5 mal in 5 s geschüttelt. Die Schaumhöhe wurde als Differenz zwischen Flüssigkeitsspiegel und Schaumkrone nach 5,10 und 15 Minuten abgelesen.

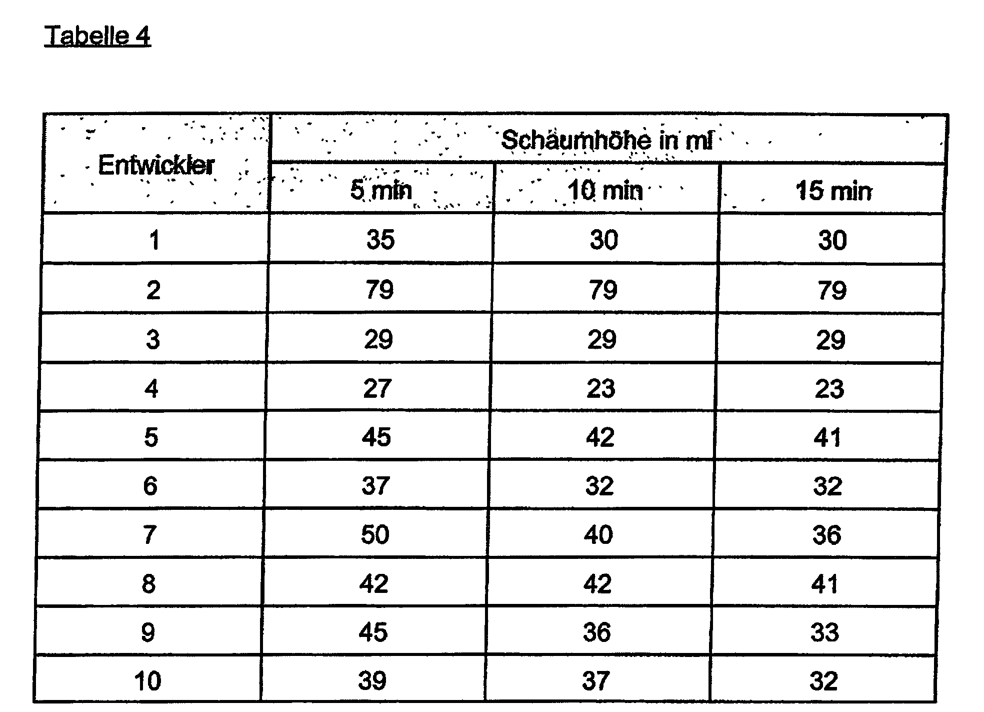

### Beispiel 4

Alle Entwickler der Tabelle 1 wurden einem Gefriertest unterzogen. Dazu wurden 100 ml des Entwicklers 24 Stunden bei -20 °C eingefroren und danach wieder aufgetaut. Die Beurteilung erfolgte nach Erwärmung auf Raumtemperatur (ca. 25 °C).

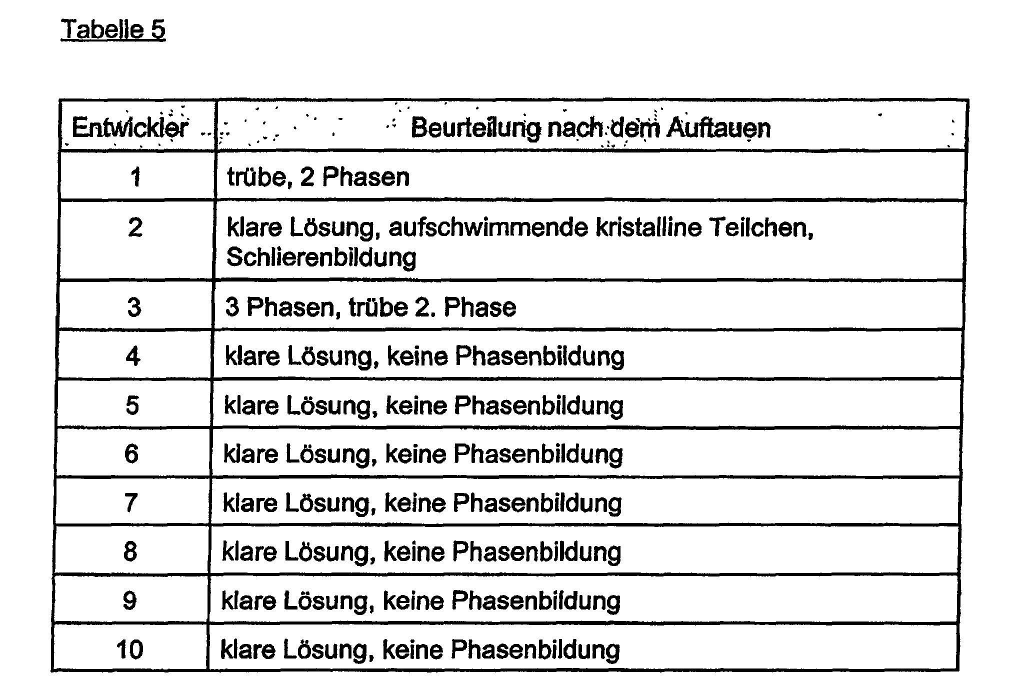

### Beispiel 5

Die Entwickler der Tabelle 1 wurden als Konzentrate mit der 5-fachen Feststoffkonzentration angesetzt und mit entionisiertem Wasser auf 100 Gt aufgefüllt. Danach wurden die Konzentrate dem Gefriertest unterzogen. Im Verdünnungstest wurde 1 Gt Entwickler des Gefriertests mit 4 Gt Leitungswasser mit 12°dH (12 Grad deutscher Härte) gemischt und die Bildung von Niederschlägen oder Phasen beobachtet.

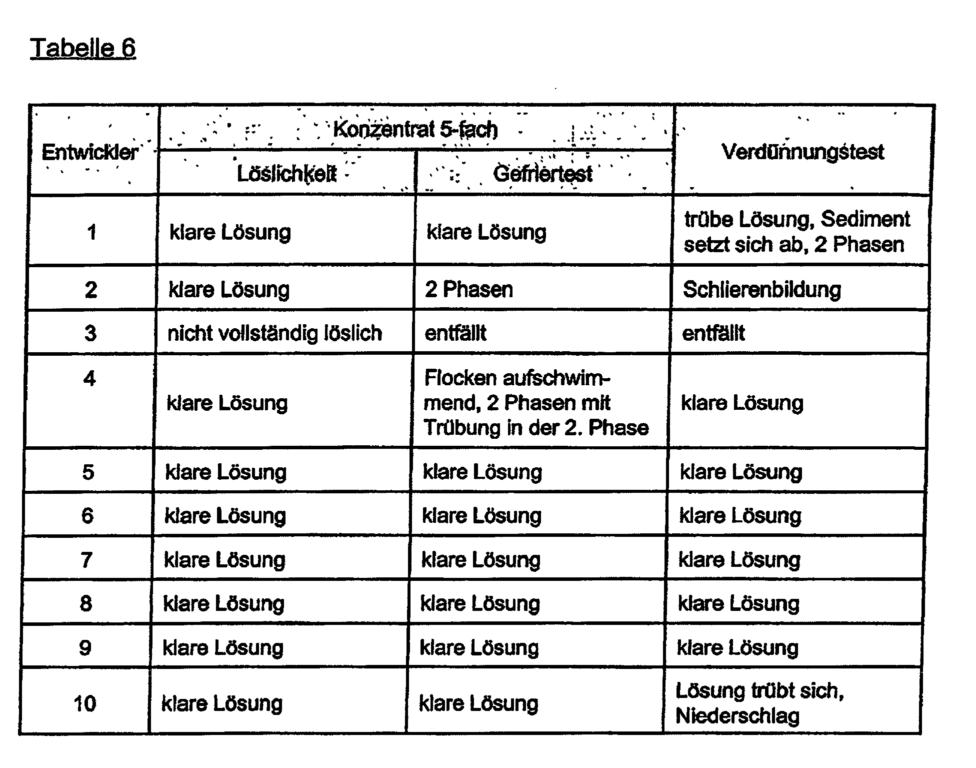

### Beispiel 6

Belichtete Druckplatten N90A wurden vergleichend in den Entwicklern der Tabellen 1 und 7 in einer Laborentwicklungsmaschine mit zwei oszillierenden Bürsten und einer Durchlaufgeschwindigkeit von 0,6 m/min entwickelt und die entwickelten Platten manuell mit Wasser abgebraust. Die Stufen des Stufenkeiles wurden mit einem Remissionsdensitometer D19C der Firma Gretag vermessen. Die Empfindlichkeit wurde angegeben in Keilstufen mit gleicher Dichte mit einer Maximalabweichung Dichtedifferenz ΔD=±0,02. Der Farbschleier wurde auf den schichtfreien Stellen einer beschichteten, belichteten und entwickelten Druckplatte im Vergleich zu einem unbeschichteten Druckplattenträger gemessen; hier galt ebenfalls eine Dichtetoleranz von ΔD=±0,02.

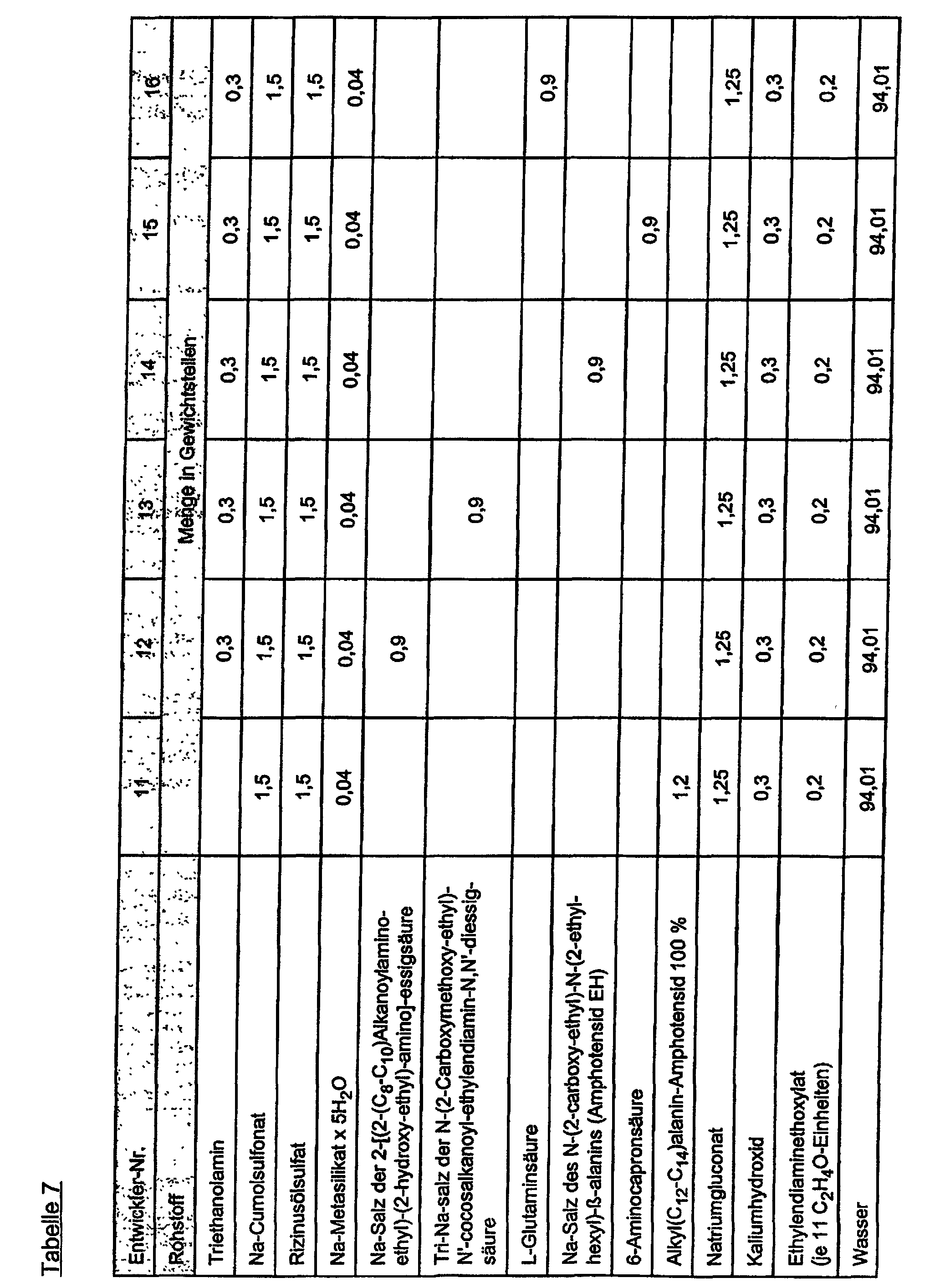

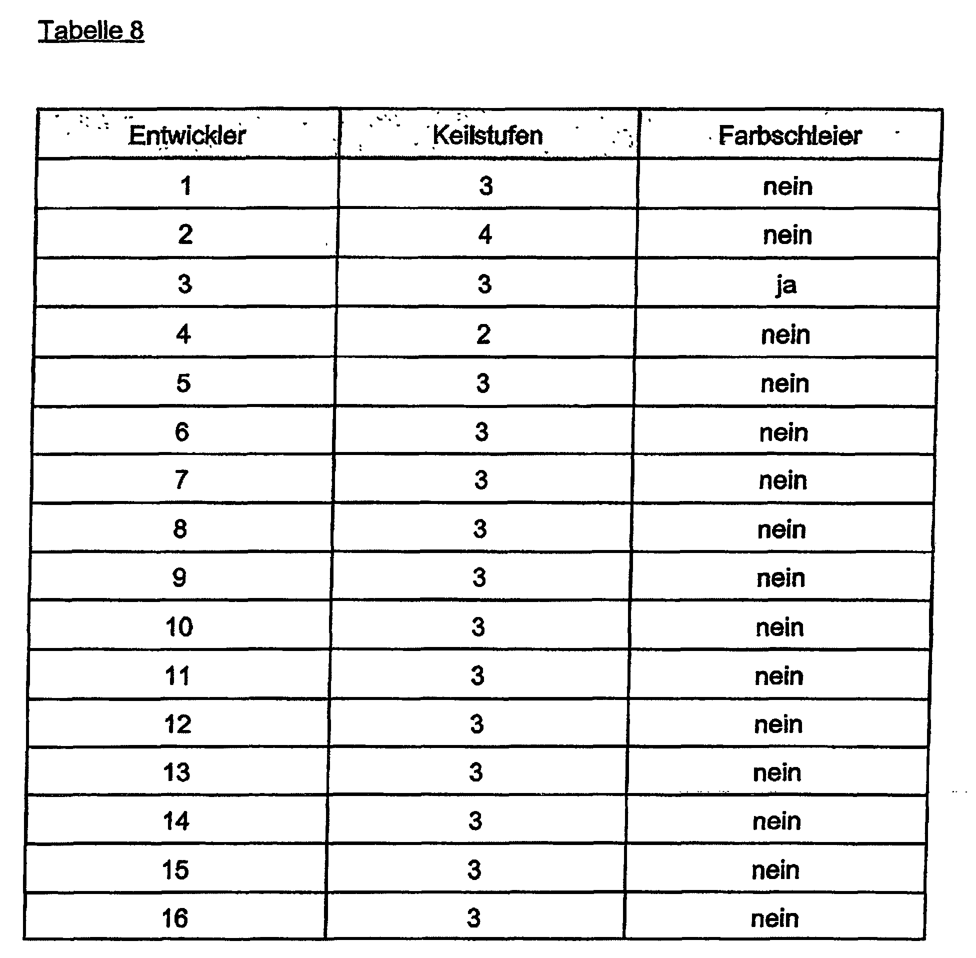

Die Entwickler 1 und 5 bis 14 zeigten ein ähnliches Entwicklungsergebnis, die entwickelten Platten unterschieden sich meßtechnisch nicht. Entwickler 2 entwickelte die Platte nicht ausreichend gut auf und Entwickler 3 hinterließ einen unerwünschten Farbschleier. Entwickler 4 entwickelte die Platte stärker auf als die anderen Entwickler. Um das gleiche Belichtungsergebnis zu erhalten wie der Vergleichsentwickler, mußte diese Platte länger oder stärker belichtet werden.

### Beispiel 7

Positivdruckplatten ®Ozasol P51 wurden in einem UV-Belichtungsrahmen durch einen UGRA-Offset Testkeil 1982 unter einem eisendotierten Quecksilber-Hochdruck-Brenner 100 Takte lang belichtet, so daß nach der Entwicklung mit einem ®Ozasol EP260-Entwickler zwei Stufen frei waren. Weitere Testplatten wurden auf die gleiche Weise belichtet, aber mit den Entwicklern 17 bis 22 gemäß Tabelle 9 entwickelt. Die Entwicklungsergebnisse waren gleich gut, insbesondere die Gradation war praktisch gleich.

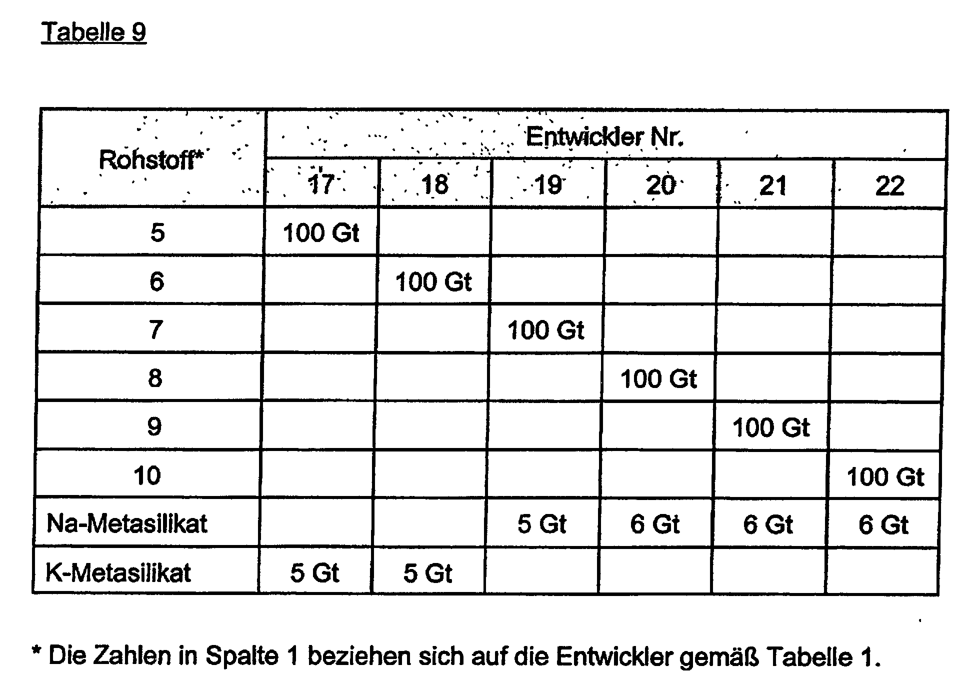

### Beispiel 8

Wie in Beispiel 7 wurden Positivdruckplatten Howson ®Alympia belichtet. Anschließend wurden die belichteten Platten 2 min lang bei 145 °C im Umlufttrockenschrank gelagert. Dadurch wurde die Bildumkehr herbeigeführt. Die Entwicklung der so behandelten Druckplatten erfolgte ebenfalls wie in Beispiel 7. Auch die Ergebnisse entsprachen denen von Beispiel 7.

## Patentansprüche

1. Entwicklerkonzentrat, das Wasser,
- mindestens ein in Wasser alkalisch reagierendes Mittel und
- ein amphoteres Tensid
enthält, **dadurch gekennzeichnet, dass** es zusätslich
- mindestens ein anionisches Tensid,
- mindestens einen Komplexbildner,
- mindestens einen Aminoalkohol, **dadurch gekennzeichnet, dass** der Aminoalkohol ein primäres, sekundäres oder tertiäres aliphatisches Amin mit mindestens einer, bevorzugt 2 bis 5 Hydroxylgruppen, vorzugweise primären oder sekundären Hydroxylgruppen, ist, und
- mindestens N-alkoxyliertes ein- oder mehrfunktionelles Amin
enthält.

2. Entwicklerkonzentrat gemäß Anspruch 1, **dadurch gekennzeichnet, daß** das in Wasser alkalisch reagierende Mittel ein Alkali-, Erdalkali- oder Ammoniumhydroxid, insbesondere LiOH, KOH oder NaOH oder ein Alkali-, Erdalkali- oder Ammoniumsalz einer anorganischen oder organischen Säure, insbesondere Natrium- oder Kaliumdihydrogenphosphat, Dinatriumoder Dikaliumhydrogenphosphat, Natrium- oder Kaliummetasilikat, Natriumborat, ein Alkalimetallsalz einer aliphatischen, aromatischen oder araliphatischen Carbonsäure, insbesondere ein Alkalimetallsalz einer (C₂-C₁₀)Alkansäure oder einer (C₃-C₁₂)Alkoxyalkansäure ist.

3. Entwicklerkonzentrat gemäß Anspruch 2, **dadurch gekennzeichnet, daß** der Anteil des alkalisch wirkenden Mittels 0,5 bis 25 Gew.-%, bevorzugt 0,7 bis 15 Gew.-%, jeweils bezogen auf das Gesamtgewicht des Konzentrats, beträgt.

4. Entwicklerkonzentrat gemäß Anspruch 1, **dadurch gekennzeichnet, daß** der pH-Wert mindestens 11, bevorzugt mindestens 12, beträgt.

5. Entwicklerkonzentrat gemäß Anspruch 1, **dadurch gekennzeichnet, daß** das amphotere Tensid bevorzugt eine Aminosäure oder ein Salz davon oder ein Alkylamidoalkylbetain der Formel
CₙH₂ₙ₊₁-CO-NH-CₘH₂ₘ-N⁺((C₁-C₆)Alkyl)₂-CₚH₂ₚ-X⁻
ist, wobei
X⁻ eine Carboxylat-, Sulfonat-, Sulfat- oder Phosphonatgruppe darstellt,
n eine ganze Zahl von 8 bis 25 sowie
m, p jeweils eine ganze Zahl von 2 bis 10.

6. Entwicklerkonzentrat gemäß Anspruch 5, **dadurch gekennzeichnet, daß** der Anteil des amphoteren Tensids 0,3 bis 25 Gew.-%, bevorzugt 0,5 bis 15 Gew.-%, jeweils bezogen auf das Gesamtgewicht des Konzentrats, beträgt.

7. Entwicklerkonzentrat gemäß Anspruch 5, **dadurch gekennzeichnet, daß** das anionische Tensid ein gegebenenfalls substituiertes (C₂-C₁₆)Alkylsulfat, (C₆-C₁₂)Arylsulfat, (C₇-C₂₀)Aralkylsulfat, (C₁-C₁₅)Alkyl-(C₆-C₁₂)Arylsulfat, (C₂-C₁₆)Alkenylsulfat oder (C₃-C₁₆)Alkoxyalkylsulfat ist.

8. Entwicklerkonzentrat gemäß Anspruch 7, **dadurch gekennzeichnet, daß** der Anteil der anionischen Tenside 0,5 bis 20 Gew.-%, bevorzugt 1 bis 15 Gew.-%, jeweils bezogen auf das Gesamtgewicht des Konzentrats, beträgt.

9. Entwicklerkonzentrat gemäß Anspruch 1, **dadurch gekennzeichnet, daß** der Komplexbildner Gluconsäure, ein Alkali-, Erdalkali-oder Ammoniumsalz der Gluconsäure oder Gluconsäure*-delta*-lacton ist.

10. Entwicklerkonzentrat gemäß Anspruch 9, **dadurch gekennzeichnet, daß** der Anteil der Komplexbildner 2 bis 20 Gew.-%, bevorzugt 4 bis 15 Gew.-%, jeweils bezogen auf das Gesamtgewicht des Konzentrats, beträgt.

11. Entwicklerkonzentrat gemäß Anspruch 1, **dadurch gekennzeichnet, daß** das N-alkoxylierte, ein- oder mehrwertige Amin ein ethoxyliertes oder propoxyliertes (C₁-C₁₀)Alkylamin, (C₂-C₁₀)Alkylendiamin, Triamin oder Tetraamin ist.

12. Entwicklerkonzentrat gemäß Anspruch 11, **dadurch gekennzeichnet, daß** der Anteil der N-alkoxylierten, ein- oder mehrwertigen Amine 0,2 bis 20 Gew.-%, bevorzugt 0,4 bis 10 Gew.-%, jeweils bezogen auf das Gesamtgewicht des Konzentrats, beträgt.

13. Entwicklerkonzentrat gemäß Anspruch 1, **dadurch gekennzeichnet, daß** es aliphatische oder aromatische Alkohole, speziell (C₁-C₁₂)Alkanole, (C₃-C₂₀)Alkoxyalkanole, gegebenenfalls substituiertes Phenol oder Benzylalkohol und nichtionische Tenside, bevorzugt alkoxylierte (speziell ethoxylierte oder propoxylierte), gesättigte oder ungesättigte aliphatische oder aromatische Alkohole, enthält.

14. Entwicklerkonzentrat gemäß Anspruch 13, **dadurch gekennzeichnet, daß** der Anteil der nichtionischen Tenside 0,1 bis 20 Gew.-%, bevorzugt 0,5 bis 12 Gew.-%, beträgt.

15. Entwickler, **dadurch gekennzeichnet, daß** er durch Verdünnen des Konzentrats gemäß einem oder mehreren der Ansprüche 1 bis 14 mit Leitungswasser im Verhältnis von 1 : 0,5 bis 1 : 10, bevorzugt im Verhältnis von 1 : 2 bis 1 : 6 hergestellt ist.

16. Verwendung des Entwicklers gemäß Anspruch 15 für die Herstellung von Druckformen für den Flach-, Hoch-, Tief- oder Siebdruck sowie von Photoresists, Reliefkopien, Gerbbildern oder Pigmentbildern.

17. Verfahren zur Herstellung einer Druckform, wobei man auf einen Träger, vorzugsweise aus Aluminium oder dessen Legierungen, der insbesondere mechanisch und/oder chemisch und/oder elektrochemisch vorbehandelt und/oder hydrophiliert ist, eine positiv, negativ oder im Umkehrverfahren arbeitende Reproduktionsschicht aufbringt, bildmäßig belichtet und anschließend mit einem Entwickler gemäß den Ansprüchen 15 und 16 entwickelt.

18. Regeneratkonzentrat mit einer Zusammensetzung wie in den Ansprüchen 1 bis 14 angegeben, **dadurch gekennzeichnet, daß** darin die Konzentration des mindestens einen in Wasser alkalisch reagierenden Mittels 10 bis 700 %, bevorzugt 50 bis 300 %, höher ist und die Konzentrationen der anderen Bestandteile bis zu 70 %, bevorzugt bis zu 50 %, von denen im Entwicklerkonzentrat abweichen.

19. Regenerat, **dadurch gekennzeichnet, daß** es durch Verdünnen des Konzentrats gemäß Anspruch 18 mit Leitungswasser im Verhältnis von 1 : 0,5 bis 1 : 10, bevorzugt im Verhältnis von 1 : 2 bis 1 : 6, hergestellt ist.

## Claims

1. A developer concentrate which comprises water,
- at least one agent which is alkaline in water and
- an amphoteric surfactant,
wherein said concentrate additionally comprises
- at least one anionic surfactant,
- at least one complexing agent,
- at least one amino alcohol, wherein the amino alcohol is a primary, secondary or tertiary aliphatic amine having at least one, preferably from 2 to 5, hydroxyl groups, preferably primary or secondary hydroxyl groups, and
- at least one N-alkoxylated mono- or polyfunctional amine.

2. The developer concentrate according to claim 1, wherein the agent which is alkaline in water is an alkali metal, an alkaline earth metal or ammonium hydroxide, in particular LiOH, KOH or NaOH, or an alkali metal, alkaline earth metal or ammonium salt of an inorganic or organic acid, in particular sodium or potassium dihydrogen phosphate, disodium or dipotassium hydrogen phosphate, sodium or potassium metasilicate, sodium borate, an alkali metal salt of an aliphatic, aromatic or araliphatic carboxylic acid, in particular an alkali metal salt of a (C₂-C₁₀)alkanoic acid or of a (C₃-C₁₂)alkoxyalkanoic acid.

3. The developer concentrate according to claim 2, wherein the amount of the alkaline agent is from 0.5 to 25% by weight, preferably from 0.7 to 15% by weight, based in each case on the total weight of the concentrate.

4. The developer concentrate according to claim 1, wherein the pH is at least 11, preferably at least 12.

5. The developer concentrate according to claim 1, wherein the amphoteric surfactant is preferably an amino acid or a salt thereof or an alkylamidoalkylbetaine of the formula
CₙH₂ₙ₊₁-CO-NH-CₘH₂ₘ-N⁺((C₁-C₆)alkyl)₂-CₚH₂ₚ-X⁻
in which
X⁻ is a carboxylate, sulfonate, sulfate or phosphonate group,
n is an integer from 8 to 25 and
m, p are each an integer from 2 to 10.

6. The developer concentrate according to claim 5, wherein the amount of the amphoteric surfactant is from 0.3 to 25% by weight, preferably from 0.5 to 15% by weight, based in each case on the total weight of the concentrate.

7. The developer concentrate according to claim 5, wherein the anionic surfactant is an unsubstituted or substituted (C₂-C₁₆)alkylsulfate, (C₆-C₁₂)arylsulfate, (C₇-C₂₀)aralkylsulfate, (C₁-C₁₅)alkyl-(C₆-C₁₂)arylsulfate, (C₂-C₁₆)alkenylsulfate or (C₃-C₁₆)alkoxyalkylsulfate.

8. The developer concentrate according to claim 7, wherein the amount of the anionic surfactant is from 0.5 to 20% by weight, preferably from 1 to 15% by weight, based in each case on the total weight of the concentrate.

9. The developer concentrate according to claim 1, wherein the complexing agent is gluconic acid, an alkali metal, alkaline earth metal or ammonium salt of gluconic acid or the *delta*-lactone of gluconic acid.

10. The developer concentrate according to claim 9, wherein the amount of the complexing agent is from 2 to 20% by weight, preferably from 4 to 15% by weight, based in each case on the total weight of the concentrate.

11. The developer concentrate according to claim 1, wherein the N-alkoxylated, mono- or polyfunctional amine is an ethoxylated or propoxylated (C₁-C₁₀)alkylamine, (C₂-C₁₀)alkylenediamine, triamine or tetraamine.

12. The developer concentrate according to claim 11, wherein the amount of the N-alkoxylated, mono- or polyfunctional amines is from 0.2 to 20% by weight, preferably from 0.4 to 10% by weight, based in each case on the total weight of the concentrate.

13. The developer concentrate according to claim 1, which contains aliphatic or aromatic alcohols, especially (C₁-C₁₂)alkanols, (C₃-C₂₀)alkoxyalkanols, unsubstituted or substituted phenol or benzyl alcohol and nonionic surfactants, preferably alkoxylated (especially ethoxylated or propoxylated), saturated or unsaturated aliphatic or aromatic alcohols.

14. The developer concentrate according to claim 13, wherein the amount of the nonionic surfactants is from 0.1 to 20% by weight, preferably from 0.5 to 12 % by weight.

15. A developer which is prepared by diluting the concentrate according to any of claims 1 to 14 with tap water in the ratio of from 1 : 0.5 to 1 : 10, preferably in the ratio of from 1 : 2 to 1 : 6.

16. The use of the developer according to claim 15 for the production of printing forms for lithographic, letterpress, gravure or screen printing and of photoresists, relief copies, tanned images or pigment images.

17. A process for the production of a printing form, a positive-working, negative-working or image reversal reproduction layer being applied to a support, preferably of aluminum or alloys thereof, which is in particular mechanically and/or chemically and/or electrochemically pretreated and/or hydrophilized, and said reproduction layer being exposed imagewise and then being developed with a developer according to any of claims 15 and 16.

18. A replenisher concentrate having a composition as stated in any of claims 1 to 14, wherein the concentration of the at least one agent which is alkaline in water in said concentrate is from 10 to 700%, preferably from 50 to 300%, higher and the concentrations of the other components differ from those in the developer concentrate by up to 70%, preferably up to 50%.

19. A replenisher which is prepared by diluting the concentrate according to claim 18 with tap water in the ratio of from 1 : 0.5 to 1 : 10, preferably in the ratio of from 1 : 2 to 1 : 6.

## Revendications

1. Concentrat de révélateur qui contient
- de l'eau,
- au moins un agent à réaction de type alcalin dans de l'eau, et
- un agent tensioactif amphotère,
**caractérisé en ce qu'**il contient en outre
- au moins un agent tensioactif anionique,
- au moins un formateur de complexes,
- au moins un aminoalcool **caractérisé en ce que** l'aminoalcool est une amine aliphatique primaire, secondaire ou tertiaire comprenant au moins un groupe hydroxyle, de préférence de 2 à 5 groupes hydroxyle, de préférence 2 à 5 groupes hydroxyle primaires ou secondaires, et
- au moins une amine monofonctionnelle ou polyfonctionnelle alcoxylée sur l'atome d'azote.

2. Concentrat de révélateur selon la revendication 1, **caractérisé en ce que** l'agent à réaction de type alcalin dans de l'eau est un hydroxyde de métal alcalin, de métal alcalino-terreux ou d'ammonium, en particulier LiOH, KOH ou NaOH, ou un sel de métal alcalin, de métal alcalino-terreux ou d'ammonium d'un acide inorganique ou organique, en particulier le dihydrogénophosphate de sodium ou de potassium, l'hydrogénophosphate disodique ou dipotassique, le métasilicate de sodium ou de potassium, le borate de sodium, un sel de métal alcalin d'un acide carboxylique aliphatique, aromatique ou araliphatique, en particulier un sel de métal alcalin d'un acide alcanoïque contenant de 2 à 10 atomes de carbone ou d'un acide alcoxyalcanoïque contenant de 3 à 12 atomes de carbone.

3. Concentrat de révélateur selon la revendication 2, **caractérisé en ce que** la fraction de l'agent à activité alcaline s'élève de 0,5 à 25 % en poids, de préférence de 0,7 à 15 % en poids, chaque fois rapportés au poids total du concentrat.

4. Concentrat de révélateur selon la revendication 1, **caractérisé en ce que** la valeur de pH s'élève à au moins 11, de préférence à au moins 12.

5. Concentrat de révélateur selon la revendication 1, **caractérisé en ce que** l'agent tensioactif amphotère représente de préférence un aminoacide ou un sel de ce dernier ou encore une alkylamidoalkyl-bétaïne répondant à la formule
CₙH₂ₙ₊₁-CO-NH-CₘH₂ₘ N⁺(alkyl en C₁-C₆)₂-CₚH₂ₚ-X⁻
dans laquelle
X⁻ représente un groupe carboxylate, un groupe sulfonate, un groupe sulfate ou un groupe phosphonate,
n représente un nombre entier de 8 à 25, et
m, p représentent respectivement un nombre entier de 2 à 10.

6. Concentrat de révélateur selon la revendication 5, **caractérisé en ce que** la fraction de l'agent tensioactif amphotère représente de 0,3 à 25 % en poids, de préférence de 0,5 à 15 % en poids, chaque fois rapportés au poids total du concentrat.

7. Concentrat de révélateur selon la revendication 5, **caractérisé en ce que** l'agent tensioactif anionique représente un groupe alkyl(en C₂-C₁₆)sulfate, un groupe aryl(en C₆-C₁₂)sulfate, un groupe aralkyl(en C₇-C₂₀)sulfate, un groupe alkyl(en C₁-C₁₅)aryl(en C₆-C₁₂)sulfate, un groupe alcényl(en C₂-C₁₆)sulfate ou un groupe alcoxalkyl(en C₃-C₁₆)sulfate.

8. Concentrat de révélateur selon la revendication 7, **caractérisé en ce que** la fraction de l'agent tensioactif anionique représente de 0,5 à 20 % en poids, de préférence de 1 à 15 % en poids, chaque fois rapportés au poids total du concentrat.

9. Concentrat de révélateur selon la revendication 1, **caractérisé en ce que** le formateur de complexes est l'acide gluconique, un sel de métal alcalin, de métal alcalino-terreux ou d'ammonium de l'acide gluconique ou encore la *delta*-lactone de l'acide gluconique.

10. Concentrat de révélateur selon la revendication 9, **caractérisé en ce que** la fraction du formateur de complexes représente de 2 à 20 % en poids, de préférence de 4 à 15 % en poids, chaque fois rapportés au poids total du concentrat.

11. Concentrat de révélateur selon la revendication 1, **caractérisé en ce que** l'amine monovalente ou polyvalente alcoxylée sur l'atome d'azote est une alkyl(en C₁-C₁₀)amine éthoxylée ou propoxylée, une alkylène(en C₂-C₁₀)diamine, une triamine ou une tétraamine.

12. Concentrat de révélateur selon la revendication 9, **caractérisé en ce que** la fraction de l'amine monovalente ou polyvalente alcoxylée sur l'atome d'azote représente de 0,2 à 20 % en poids, de préférence de 0,4 à 10 % en poids, chaque fois rapportés au poids total du concentrat.

13. Concentrat de révélateur selon la revendication 1, **caractérisé en ce qu'**il contient des alcools aliphatiques ou aromatiques, en particulier des alcanols en C₁-C₁₂, des alcoxyalcanols en C₃-C₂₀, un phénol le cas échéant substitué ou de l'alcool benzylique et des agents tensioactifs non ioniques, des alcools aliphatiques ou aromatiques, saturés ou insaturés, de préférence alcoxylés (de manière spécifique éthoxylés ou propoxylés).

14. Concentrat de révélateur selon la revendication 13, **caractérisé en ce que** la fraction de l'agent tensioactif non ionique représente de 0,1 à 20 % en poids, de préférence de 0,5 à 12 % en poids.

15. Révélateur, **caractérisé en ce qu'**on le prépare par dilution du concentrat selon une ou plusieurs des revendications 1 à 14, avec de l'eau de distribution dans le rapport de 1 : 0,5 à 1 : 10, de préférence dans le rapport de 1 : 2 à 1 : 6.

16. Utilisation du révélateur selon la revendication 15 pour la fabrication de clichés d'impression pour la planographie, pour la typographie, pour l'héliogravure ou pour la sérigraphie, et pour la fabrication de réserves photographiques, de copies en relief, d'images tannées ou d'images pigmentées.

17. Procédé pour la fabrication de clichés d'impression dans lequel on applique sur un support, de préférence constitué d'aluminium ou d'alliages de ce dernier qui a été soumis à un traitement préalable en particulier par voie mécanique et/ou par voie chimique et/ou par voie électrochimique et/ou qui a été rendu hydrophile, une couche de reproduction travaillant en mode positif, en mode négatif ou dans un procédé par inversion, on expose en forme d'image et on développe ensuite avec un révélateur conformément aux revendications 15 et 16.

18. Concentrat de produit de régénération dont la composition est indiquée dans les revendications 1 à 14, **caractérisé en ce que** la concentration qui y est contenue de l'agent ou des agents du type à réaction alcaline dans de l'eau est supérieure à concurrence de 10 à 700 %, de préférence de 50 à 300 % et les concentrations des autres constituants s'écartent de celles présentes dans le concentrat de révélateur jusqu'à concurrence de 70 %, de préférence jusqu'à concurrence de 50 %

19. Produit de régénération, **caractérisé en ce qu'**on le prépare par dilution du concentrat selon la revendication 18 avec de l'eau de distribution dans le rapport de 1 : 0,5 à 1 : 10, de préférence dans le rapport de 1 : 2 à 1 : 6.
